(19) Europäisches Patentamt

European Patent Office

Office européen des brevets

(11) Publication number: **0 424 023 A2**

# EUROPEAN PATENT APPLICATION

(21) Application number: **90311113.6**

(22) Date of filing: **10.10.90**

(51) Int. Cl.[5]: **C04B 35/00, C04B 35/64, H01L 39/24**

(30) Priority: **14.10.89 KR 1474489**

(43) Date of publication of application:
**24.04.91 Bulletin 91/17**

(84) Designated Contracting States:
**DE FR GB NL**

(71) Applicant: **GOLD STAR CO. LTD**
**20 Yoido-Dong, Youngdungpo-ku**
**Seoul(KR)**

(72) Inventor: **Lee, Pil Hwa**
**77-1 Oncheon-dong, Dongrae-ku**
**Pusan(KR)**

(74) Representative: **Carmichael, David Andrew**
**Halliday et al**
**G.F. REDFERN & CO. High Holborn House**
**52/54 High Holborn**
**London WC1V 6RL(GB)**

(54) **Bi-Pb series superconductor and manufacturing process thereof.**

(57) A superconductor of Bi-Pb-Sr-Ca-Cu-O series and a manufacturing process are disclosed. First, $Bi_2O_3$, $SrCo_3$, $CaCo_3$, and $CuO$ are measured in proper ratios, and they are mixed together, before they are crushed. The mixture is calcinated two or three times at a temperature at 600 - 750° C, and then, the mixture is crushed again. Then the mixture is sintered at a temperature at 800 -900° C to obtain a composition of Bi4, Sr4.5, Ca4.5, Cu6 and Oy. Then Pb is added to the composition in the amount of a 1 - 2 mole ratio, and then, the mixture is sintered at a temperature of 800 -850° C for 20 to 80 hours. According to the present invention, the time period required for carrying out the process is shortened, therebvy improving the economic feature of the process.

F I G . 1

## BI-PB SERIES SUPERCONDUCTOR AND MANUFACTURING PROCESS THEREOF

Field of the invention

The present invention relates to a novel Bi-Pb series superconductor and a manufacturing process thereof.

Background of the invention

In the conventional Bi-Pb series high temperature superconductor, Bi is partly replaced with Pb, thereby forming a Bi-Pb-Sr-Ca-Cu-O series. According to this method, however, there is the difficulty that the amounts of the raw material powders such as $Bi_2O_3$ , PbO, $SrCo_3$ , $CaCo_3$ and CuO have to be calculated before they are mixed together. Further, the periods of carrying out the calcination and sintering are extended to over 15 days, and the lengthy heat treating process results in the vaporization of Pb to an excessive degree.

Thus due to the consequent dificiency of Pb, the desired composition can not be easily repeatedly reproduced, while the sintering requires over 7 days, thereby aggravating the economic feature of the process.

Summary of the invention

The present invention is intended to overcome the above described disadvantages of the conventional process.

Therefore, it is the object of the present invention to provide a new superconductor of Bi-Pb-Sr-Ca-Cu-O series which is manufactured by adding Pb to the Bi-Sr-Ca-Cu-O series.

Brief description of the drawings

The above object and other advantages of the present invention will become more apparent by describing in detail the preferred embodiment of the present invention with reference to the attached drawings in which :

Figure 1 is a graphical illustration of the results of X-ray diffrac tions as against the sintering time ;

Figure 2 is a graphical illustration of the variation of the specific resistivity as against the varilations of the temperature and the sintering time ; and

Figure 3 is a graphical illustration of the inductance variation as against the variations of the temperature and the sintering time.

Desceiption of the preferred embodiment

The raw material powders of $Bi_2O_3$ , $SrCo_3$ , $CaCo_3$ , and CuO are measured in the desired mole ratios, are added together and crushed by means of a ball mill, and then, calcinations are carried out two or three times at a temperature of 600 - 750° C. Thereafter, a crushing by means of a ball mill is carried out again, and then, a sintering is carried out at a temperature of 800 - 900° C, thereby obtaining a composition having mole ratios of $Bi_{2-4}$ , $Sr_9$ or less, $Ca_9$ or less, $Cu_{1-6}$ and $O_y$ - (stoichiometrical residue mole). To the composition obtained as described above, Pb is added in the amount of 1 - 2 mole ratio, and then a sintering is carried out again at a temperature of 800 - 850° C for 20 - 30 hours, thereby obtaining a composition thus obtained is subjected to an X-ray diffraction inspection to evaluate it, and then, a sintering is carried out at a temperature of 800 - 850° C. The pellet thus obtained is fabricated into the desired shape, and its electric and magnetic characteristics are inspected in order to know the critical temperature before evaluating it.

According to the present invention as described above, the Bi-Sr-Ca-Cu-O series is formed first, and then, Pb is added into it. Thus the heat treating process becomes very short, and therefore, the avoiding of the deficiency of Pb enables to improve the reproductivity, so that the productivity should be improved ultimately. An actual example will be presented below.

Example

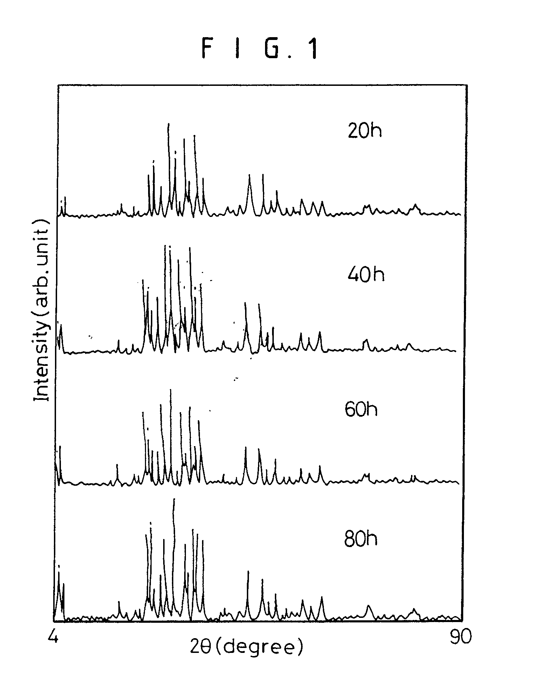

Compositions having mole ratios of $Bi_{2-4}$ , $Pb_{1-2}$ , $Sr_9$ or less, $Ca_9$ or less, $Cu_{1-6}$ and $O_y$ were sintered for 20, 40, 60 and 80 hours respectively, and they were subjected to X-ray diffraction tests. The results of the tests was that, as shown in Figure 1, that is, as shown by the black dot before $2\theta = 4°$ , the supercondoctivity is retained at the higher temperature, the higher peak intensity is.

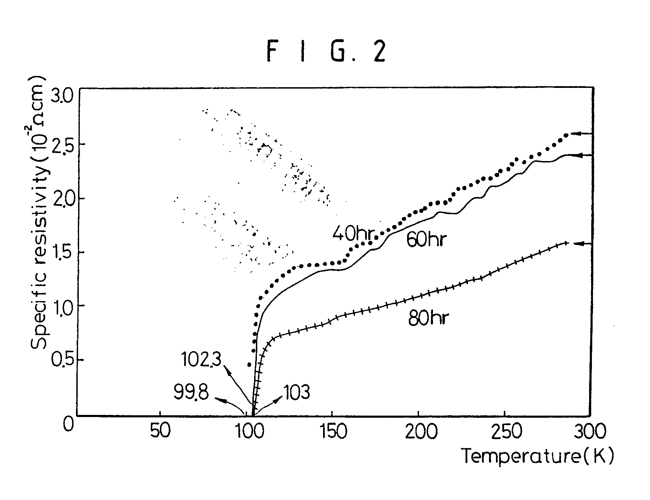

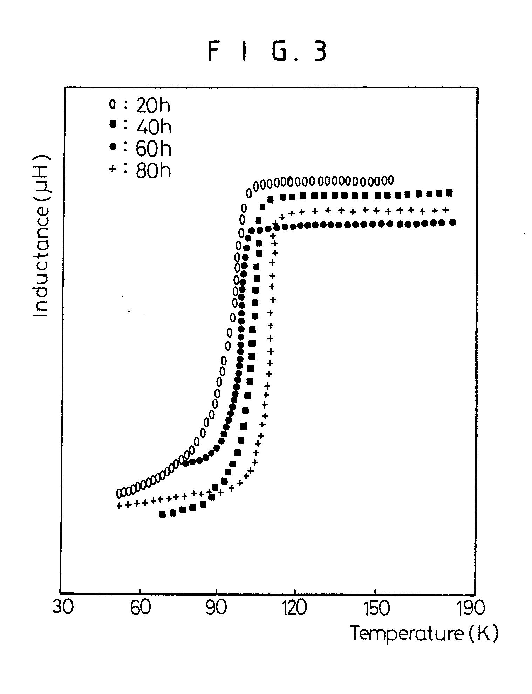

The powders which had undergone the X-ray diffraction tests were fabricated into desired shapes, and then, were subjected to tests of electric and magnetic properties, the results being as shown in Figures 2 and 3. Figure 2 graphically illustrates the variation of the specific resistivity as against the variations of the tem perature and the sintering time, and as shown in this drawing, the critical temperature TC was highest in the sample which were sintered for 80 hours.

Figure 3 graphically illustrates the variation of inductance as against the variations of the temperature and the sintering time, and this test result corresponds with the results of the X-ray diffraction test and a resistivity measurement.

## Claims

1. A Bi-Pb series superconductor comprising a composition having mole ratios of $Bi_{2-4}$, $Pb_{1-2}$, $Sr_9$ or less, $Ca_9$ or less, $Cu_{1-6}$ and $O_y$, said composition being obtained by adding Pb in the amount of a 1 - 2 mole after mixing $Bi_2O_3$, $SrCo_3$, $CaCo_3$, and CuO, crushing them, calcinating them, crushing them again, and sintering them.

2. A manufacturing process for a superconductor of Bi-Pb series superconductor comprising : step of measuring $Bi_2O_3$, $SrCo_3$, $CaCo_3$, and CuO in proper ratios ; step of mixing and crushing them ; step of calcinating the mixture two or three times at a temperature of 600 - 750°C ; step of crushing it again ; step of sintering it at a temperature of 800 - 900°C to obtain a composition of Bi4, Sr4.5, Ca4.5, Cu6 and Oy ; step of adding Pb in the amount of a 1 - 2 mole ; and step of sintering it at a temperature of 800 - 850°C for 20 to 80 hours.

# F I G . 1

# F I G. 2

F I G. 3